Europäisches Patentamt

European Patent Office

Office européen des brevets

(19)

(11) Publication number: **0 207 678 B1**

# EUROPEAN PATENT SPECIFICATION

(12)

(45) Date of publication of patent specification: **02.01.92**

(51) Int. Cl.⁵: **G01R 19/145**, G01R 31/36, A46B 15/00

(21) Application number: **86304636.3**

(22) Date of filing: **16.06.86**

(54) **Combination of a voltage testing device and an electric tooth brush.**

(30) Priority: **17.06.85 JP 131454/85**
            **17.09.85 JP 204892/85**

(43) Date of publication of application:
    **07.01.87 Bulletin 87/02**

(45) Publication of the grant of the patent:
    **02.01.92 Bulletin 92/01**

(84) Designated Contracting States:
    **CH DE FR GB IT LI**

(56) References cited:
    **EP-A- 0 105 505        EP-A- 0 174 740**
    **GB-A- 390 985         GB-A- 2 098 745**
    **GB-A- 2 124 787       US-A- 3 667 454**

(73) Proprietor: **Hukuba, Hiroshi**
    **No. 914-1, Nazukari**
    **Nagareyama-shi Chiba-ken(JP)**

(72) Inventor: **Hukuba, Hiroshi**
    **No. 914-1, Nazukari**
    **Nagareyama-shi Chiba-ken(JP)**

(74) Representative: **Bird, Vivian John et al**
    **PAGE & CO. Temple Gate House**
    **Temple Gate Bristol, BS1 6PL(GB)**

## Description

This invention relates to a combination of an electric tooth-brush and a voltage testing device for the tooth-brush.

Electric tooth-brushes are known in which a battery housed in the handle is arranged so that in use a current is passed through the body of the user between the mouth and the hand holding the brush.

One such tooth-brush is described in GB-A-390 985, in which the bristles are formed of the usual non-conducting material and one or more wires leading from the battery is or are arranged between the folds of the bristles, so that when the bristles are moistened in use a current passes from the battery through the brush to a conducting hand grip. An indicator lamp adapted to be contacted with the battery terminals may be mounted at the end of the handle to show whether the battery is in order.

It will be appreciated, however, that the provision of such integral testing means adds to the complexity and cost of the brush, which may need to be disposed of while the testing means is still usable.

In GB-A-2 124 787 a battery testing device is disclosed in which an insulating body holds an indicator lamp connected to two probes that are adapted to be contacted with the battery terminals.

The present invention provides an improved combination of an electric tooth-brush with a separate battery testing device.

According to the present invention, there is provided a combination of:

an electric tooth-brush containing a battery; and

a voltage testing device for testing the condition of the battery, said tooth-brush comprising:

an elongate handle having a grip portion at one end thereof and a head portion studded with bristles at the other end thereof, said battery being disposed in said grip portion;

an electrically conductive member mounted on the exterior of said grip portion and electrically connected to one pole of said battery; and

an electrically conductive bar disposed in said handle and extending lengthwise thereof from said battery to adjacent said bristles, one end of said bar being electrically connected to the other pole of said battery and a portion of said bar being exposed to the exterior of said head portion via at least one slot in said head portion, said voltage testing device comprising:

an elongate device body positionable adjacent said tooth-brush and extendable lengthwise thereof between said electrically conductive member and said exposed portion of said bar;

a light emitter mounted inside said body and visible from outside said body;

a pair of electrical conductors carried by said body and extending in opposite directions away from said light emitter, said conductors having exposed, longitudinally spaced-apart, outer ends projecting outwardly from said body close to opposite ends thereof and disposed at locations corresponding to the locations of said electrically conductive member and said exposed portion of said bar respectively, so that said outer ends can simultaneously touch said electrically conductive member and said exposed portion of said bar respectively, said conductors having inner ends connected to said light emitter; and

indicating means on said body for indicating the direction in which said body should be placed relative to said tooth-brush for testing said battery, whereby when said outer ends of said conductors touch said electrically conductive member and said exposed portion of said bar respectively, the emission of light by said light emitter is dependent on the condition of the battery.

The invention will now be described, by way of example, with reference to the accompanying drawings, in which:-

Fig. 1 is a bottom view showing an electric tooth-brush accommodating a battery;

Fig. 2 is a longitudinal sectional view taken on the line 2 - 2 of Fig. 1;

Fig. 3 is a side view of a voltage testing device for use in a first embodiment of the invention;

Fig. 4 is a plan view of the Fig. 3 device;

Fig. 5 is a longitudinal sectional view taken on the line 5 - 5 of Fig. 4;

Fig. 6 is a perspective view showing the voltage testing device of the first embodiment when placed in condition for measurement of the voltage of the battery incorporated in the tooth-brush;

Fig. 7 is a bottom view of a voltage testing device for use in a second embodiment of the invention;

Fig. 8 is a longitudinal sectional view taken on the line 8 - 8 of Fig. 7;

Fig. 9 is a side view of a voltage testing device for use in a third embodiment of the invention;

Fig. 10 is a cross-sectional view taken on the line 10 - 10 of Fig. 9;

Fig. 11 is a side view of a voltage testing device for use in a fourth embodiment of the invention;

Fig. 12 is a cross-sectional view taken on the line 12 - 12 of Fig. 11;

Fig. 13 is a side view showing a voltage testing device for use in a fifth embodiment of the invention;

Fig. 14 is a cross-sectional view taken on the line 14 - 14 of Fig. 3;

Fig. 15 is a plan view showing a voltage testing device for use in a sixth embodiment of the invention;

Fig. 16 is a side view of Fig. 15; and

Fig. 17 is an enlarged longitudinal sectional view of a portion in Fig. 16 indicated by an arrow-headed line 17.

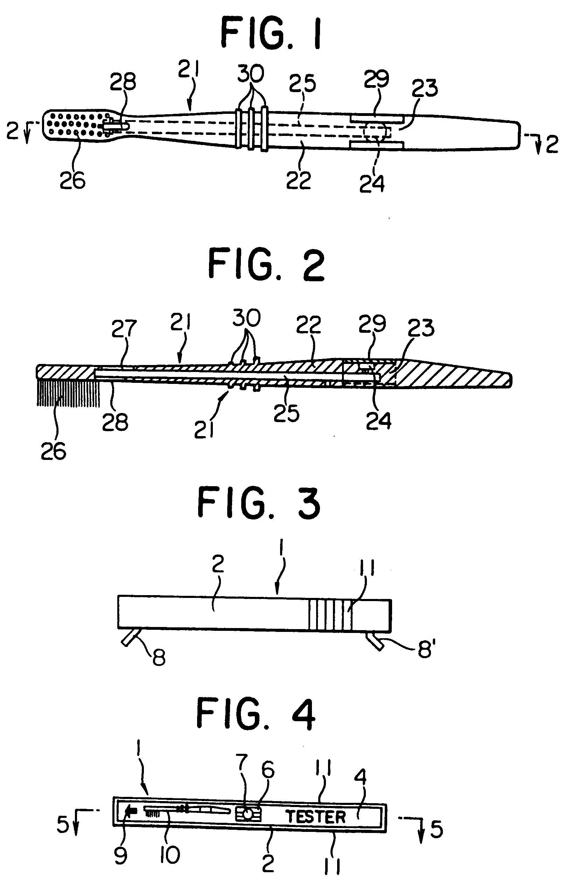

Referring to Figs. 1 and 2, an electric tooth-brush 21 has an elongate handle 22 having a grip portion 23 in which a battery 24 is accommodated. An electrically conductive bar 25 is embedded in the handle 22, having one end in contact with a negative pole of the battery 24 and the other end reaching brush bristles 26, with which a head portion of the tooth-brush is studded. Adjacent the brush bristles 26, slots 27 and 28 are formed in top and bottom surfaces of the handle 22, respectively. An electrically conductive cover plate 29 wrapping the grip portion 23 is in contact with a positive pole of the battery 24. A collar 30 is provided for blocking saliva flowing out of the brush bristles which would otherwise reach fingers grasping the grip portion.

This tooth-brush is similar to that disclosed in EP-A- 174 740 of the present applicant, which claims an earlier priority date than the present application but was not published until after that date.

During tooth brushing with the tooth-brush 21, the positive pole of the battery 24 electrically conducts to the user's hand through the cover plate 29 and the negative pole to the oral cavity through the electrically conductive bar 25 and saliva in the slot 28, thereby establishing a closed circuit. When a toothpaste containing fluoride is used, this closed circuit causes electrical permeation of fluorine ions into the teeth, thereby ensuring protection and prevention against tooth decay and pyorrhea.

Referring now to Figs. 3 to 5, a voltage testing device for use in a first embodiment of this invention has an elongate device body 1 which comprises a casing 2 formed, in its top surface, with a recess 3 and a cover 4 placed to cover the recess 3. Near axially opposite ends of the recess, holes 5 and 5' are formed in the bottom wall of the casing and an opening 6 is formed in the cover 4 substantially in the middle thereof.

A light emitter 7 such as a light emitting diode is supported so as to underlie the opening 6 within the recess 3. Thus, opposite leads of the light emitter 7 are connected with electrical wire conductors 8 and 8' which extend through the holes 5 and 5' to project outwardly of the casing 2, terminating in projections which are bent about 45° longitudinally outwardly for fixing the electrical conductors 8 and 8'. The electrical conductors 8 and 8' are respectively brought into electrical connection to the negative and positive poles of the battery 24 of the tooth-brush 21, in a manner to be described later.

Markings, including an arrow 9 and a picture 10 of a tooth-brush, are provided on the top surface of the cover 4, and opposite side surfaces of the casing 2 are corrugated at 11 near the electrical conductor 8'.

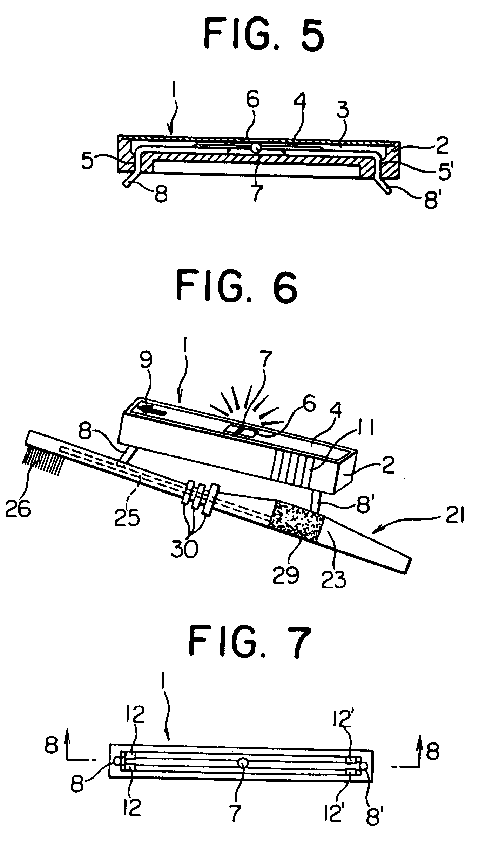

As shown in Fig. 6, the voltage testing device constructed as above is applied to the electrical tooth-brush 21 in order to measure the voltage of the battery 24 incorporated therein. More particularly, for measurement of the voltage, the testing device body 1 is carried by hand and the electrical conductor 8 is inserted into the slot 27 in the tooth-brush 21 so as to be brought into engagement with the electrically conductive bar 25 while the electrical conductor 8' is brought into engagement with the cover plate 29 of the tooth-brush 21. Then, if the voltage of the battery 24 is still above a predetermined level, the light emitter 7 will be lit but if not so, it remains unlit, thus making it possible to discern validity or invalidity of the battery 24.

When using the voltage testing device for measurement of the voltage in the manner as above, the arrow 9 and picture 10 as well as corrugations 11 aid the use to correctly put the electrical conductors 8 and 8' into electrical connection with the intended poles, that is, the negative and positive poles, respectively. Specifically, by orienting the voltage testing device in accordance with the indication by the picture 10 of a tooth-brush and the arrow 9 in the same direction as the tooth-brush 21, the electrical wire conductor 8 can rest, in a so-called automatic fashion, on the electrically conductive bar 25 in contact with the negative pole and the opposite electrical wire conductor 8' can similarly rest on the cover plate 29 in contact with the positive pole. More conveniently, the user may be experienced in knowing that the corrugations 11 are provided on the side of the electrical conductor 8', so that the same posture as above can also be obtained in a so-called automatic fashion by simply putting into engagement with the cover plate 29 the electrical conductor 8' near the corrugations 11 felt by the fingers without asking the user to pay attention to the arrow 9 and picture 10.

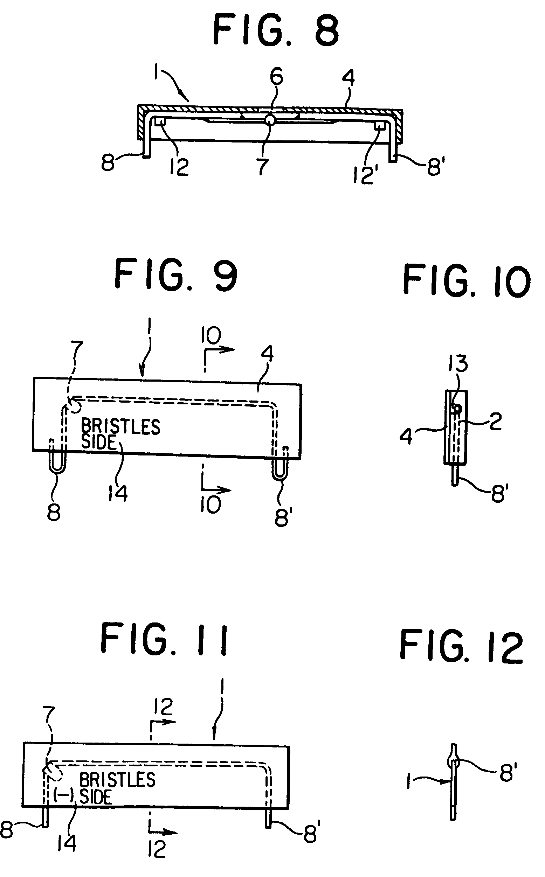

Turning to Figs. 7 and 8, there is shown a device for use in a second embodiment, which is identical to the first embodiment, with the exception that the casing 2 of the first embodiment is eliminated and instead the peripheral edge of a cover 4 is elongate downwardly, and that electrical conductors 8 and 8' are carried on a pair of opposing fixtures 12 and 12' depending from the back of the top surface of the cover 4. The testing device of the second embodiment may be used in quite the same way as that of the first embodiment.

In a testing device for use in a third embodiment, as shown in Figs. 9 and 10, a light emitter 7 and electrical wire conductors 8 and 8' are received in a recess 13 provided in a casing block 2 and a transparent cover 4 is placed to cover the casing 2. Markings 14 in the form of characters reading "BRISTLES SIDE" are provided on the cover 4. Again, the testing device of the third embodiment may be used in quite the same way as the first embodiment.

For use in a fourth embodiment of this invention, as shown in Figs. 11 and 12, a device body 1 is formed of two cards which are bonded together after a light emitter 7 and electrical conductors 8 and 8' have been sandwiched therebetween. As markings 14, a symbol (-) is applied in addition to the same characters as those of the third embodiment. Conveniently, the electrical conductors 8 and 8' of this embodiment may be of printed wiring.

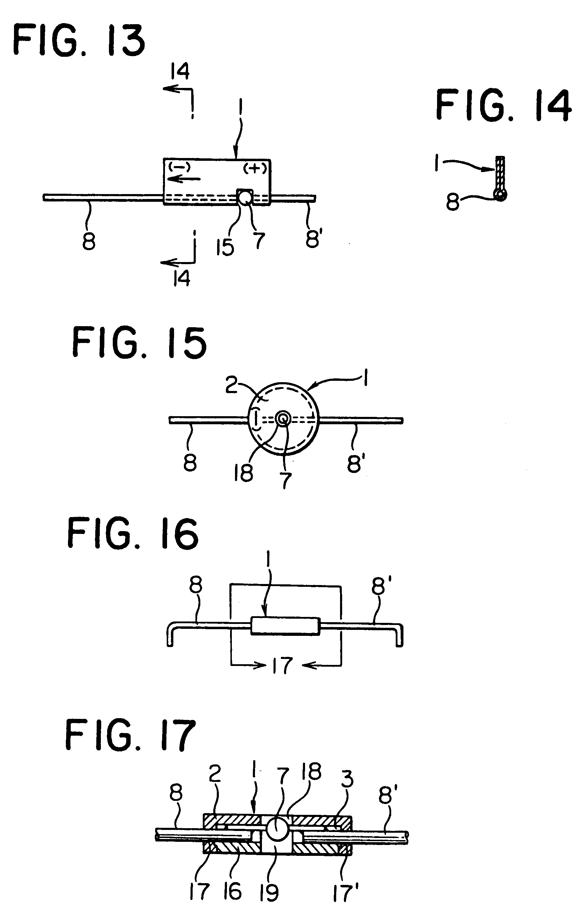

A fifth embodiment of this invention, as shown in Figs. 13 and 14, has a testing device which resembles that of the fourth embodiment but a light emitter 7 of the fifth embodiment is exposed to the outside through an opening 15 formed in a device body 1, so that activation or inactivation of the light emitter 7 can visually be observed more clearly. Used as markings are symbols (-) and (+) and an arrow. This embodiment may also be used in quite the same manner as the first embodiment.

A sixth embodiment of this invention, as shown in Figs. 15 to 17, has a testing device with a body 1 including a casing 2 formed, in its bottom surface, with a recess 3 and a bottom plate 16 snugly fitted, preferably snapped, in the recess 3. Electrical conductors 8 and 8' extend to the outside through holes 17 and 17' formed in opposite side walls of the casing 2, and a light emitter 7 can visually be observed through either an opening 18 in the casing 2 or an opening 19 in the bottom plate 16. Again, the sixth embodiment may be operated in quite the same way as the first embodiment.

**Claims**

1. A combination of:

an electric tooth-brush (21) containing a battery (24); and

a voltage testing device for testing the condition of the battery, said tooth-brush comprising:

an elongate handle (22) having a grip portion (23) at one end thereof and a head portion studded with bristles (26) at the other end thereof, said battery being disposed in said grip portion;

an electrically conductive member (29) mounted on the exterior of said grip portion and electrically connected to one pole of said battery; and

an electrically conductive bar (25) disposed in said handle and extending lengthwise thereof from said battery to adjacent said bristles, one end of said bar being electrically connected to the other pole of said battery and a portion of said bar being exposed to the exterior of said head portion via at least one slot (27, 28) in said head portion, said voltage testing device comprising:

an elongate device body (1) positionable adjacent said tooth-brush and extendable lengthwise thereof between said electrically conductive member and said exposed portion of said bar;

a light emitter (7) mounted inside said body and visible from outside said body;

a pair of electrical conductors (8,8') carried by said body and extending in opposite directions away from said light emitter, said conductors having exposed, longitudinally spaced-apart, outer ends projecting outwardly from said body close to opposite ends thereof and disposed at locations corresponding to the locations of said electrically conductive member and said exposed portion of said bar respectively, so that said outer ends can simultaneously touch said electrically conductive member and said exposed portion of said bar respectively, said conductors having inner ends connected to said light emitter; and

indicating means (9, 10, 11; or 14) on said body for indicating the direction in which said body should be placed relative to said tooth-brush for testing said battery, whereby when said outer ends of said conductors touch said electrically conductive member and said exposed portion of said bar respectively, the emission of light by said light emitter is dependent on the condition of the battery.

2. A combination according to claim 1, wherein said indicating means comprises a marking indicating which pole at least one of said electrical conductors (8,8') should be electrically connected to.

3. A combination according to claim 1 or 2, wherein said indicating means comprises characters (14).

4. A combination according to claim 3, wherein said characters (14) identify a part of the tooth-brush.

5. A combination according to any preceding claim, wherein said indicating means comprises a picture (10).

6. A combination according to any preceding claim, wherein said light emitter (7) is supported to oppose an opening (6) in said body (1).

7. A combination according to any preceding claim, wherein said body (1) comprises two members (2, 4) fitted together to form said body, the latter having an internal cavity (3) in which said light emitter (7) and said two electrical conductors (8,8') are received.

8. A combination according to claim 7, wherein said body (1) is a box-like body.

9. A combination according to claim 7, wherein said body (1) is substantially rectangular and comprises a casing (2) having an elongate recess (3) which is open at its upper side and a cover (4) covering the upper side of said recess, said cover having an opening (6) therethrough substantially at the longitudinal middle thereof, said casing having two holes (5, 5') located close to the opposite longitudinal ends of said casing and extending from said recess through the bottom of said casing, said light emitter (7) being disposed in said recess under said opening, said conductors (8, 8') being disposed in said recess and being bent to diverge in a direction away from said body and said indicating means (9, 10, 11) being provided on said cover.

10. A combination according to any of claims 1 to 6, wherein said body (1) is substantially rectangular and comprises a cover (4) having a base wall and side and end walls extending downwardly from said base wall and defining an elongate recess which is open at its bottom, said base wall having an opening (6) therethrough substantially at the longitudinal middle thereof, said light emitter (7) being disposed in said recess under said opening, said conductors (8, 8') being disposed in said recess and having said outer ends thereof projecting through the open bottom of said recess, said cover having fixtures (12, 12') for retaining said conductors in said recess and said indicating means (9, 10, 11) being provided on said cover.

**Revendications**

1. Combinaison d'une :
   brosse à dents électrique (21) contenant une batterie (24) ; et d'un

   dispositif pour le contrôle des tensions permettant de contrôler l'état de la batterie, la brosse à dents comprenant :

   un manche allongé (22) présentant à l'une de ses extrémités une partie pour la prise (23) et à l'autre de ses extrémités une tête garnie de poils (26), la batterie étant placée dans la partie de prise ;

   un organe électriquement conducteur (29) monté à l'extérieur de la partie de prise et relié électriquement à un pôle de la batterie ; et

   une barre électriquement conductrice (25) placée dans le manche et s'étendant le long de celui-ci depuis la batterie jusqu'à proximité des poils, une des extrémités de la barre étant reliée électriquement à l'autre pôle de la batterie et une partie de la barre étant exposée à l'extérieur de la tête au moyen d'au moins une fente ménagée (27,28) dans la tête, le dispositif de contrôle des tensions comprenant :

   un corps (1) allongé pouvant être placé en position adjacente à la brosse à dents et s'étendant tout au long de celle-ci entre l'organe électriquement conducteur et la partie exposée de la barre ;

   un émetteur de lumière (7) monté à l'intérieur du corps et visible depuis l'extérieur ;

   une paire de conducteurs électriques (8,8') portée par le corps et s'éloignant en direction opposée depuis l'émetteur de lumière, ces conducteurs présentant des extrémités extérieures exposées, espacées longitudinalement, se prolongeant vers l'extérieur depuis le corps à proximité de ses extrémités opposées et placés à des emplacements correspondant aux emplacements de l'organe électriquement conducteur et de la partie exposée de la barre, de façon à ce que les extrémités extérieures puissent simultanément être en contact avec l'organe électriquement conducteur et la partie exposée de la barre, ces conducteurs présentant des extrémités intérieures reliées à l'émetteur de lumière ; et

   des moyens d'indication (9,10,11 ; ou 14) sur le corps pour indiquer la direction selon laquelle le corps doit être placé par rapport à la brosse à dents afin de contrôler la batterie, de telle façon que les extrémités extérieures des conducteurs soient en contact avec l'organe électriquement conducteur et avec la partie exposée de la barre, l'émission de lumière par l'émetteur de lumière étant dépendante des conditions de la batterie.

2. Combinaison selon la revendication 1, dans laquelle les moyens d'indication comprennent un marquage indiquant à quel pôle au moins l'un des conducteurs électriques (8,8') doit être relié.

3. Combinaison selon la revendication 1 ou 2, dans laquelle les moyens d'indication comprennent des caractères (14).

4. Combinaison selon la revendication 3, dans laquelle les caractères (14) identifient une partie de la brosse à dents.

5. Combinaison selon l'une des revendications précédentes, dans laquelle les moyens d'indication comprennent une image (10).

6. Combinaison selon l'une des revendications précédentes, dans laquelle l'émetteur de lumière (7) est placé face à l'ouverture (6) ménagée dans le corps (1).

7. Combinaison selon l'une des revendications précédentes, dans laquelle le corps (1) comprend deux organes (2,4) qui y sont fixés, le deuxième organe présentant une cavité interne (3) dans laquelle sont logés l'émetteur de lumière (7) et les deux conducteurs électriques (8,8').

8. Combinaison selon la revendication 7, dans laquelle le corps (1) a une forme de boite.

9. Combinaison selon la revendication 7, dans laquelle le corps (1) est sensiblement rectangulaire et comprend une enveloppe (2) présentant un évidement allongé (3) qui est ouvert sur son côté supérieur et un couvercle (4) couvrant le côté supérieur de l'évidement, ce couvercle présentant une ouverture (6) traversante située longitudinalement sensiblement vers le milieu, cette enveloppe présentant deux perçages (5,5') placés à proximité des extrémités longitudinales opposées de l'enveloppe et s'étendant depuis l'évidement à travers le fond de l'enveloppe, l'émetteur de lumière (7) étant placé dans l'évidement en dessous de l'ouverture, les conducteurs (8,8') étant placés dans l'évidement et étant courbés pour s'éloigner en divergeant depuis le corps, et les moyens d'indication (9,10,11) étant placés sur le couvercle.

10. Combinaison selon l'une des revendications 1 à 6, dans laquelle le corps (1) est sensiblement rectangulaire et comprend un couvercle (4) présentant une paroi principale et des parois de côté et d'extrémité s'étendant vers le bas depuis la paroi principale et définissant un évidement allongé qui est ouvert au fond, la paroi principale présentant une ouverture (6) traversante longitudinalement sensiblement vers le milieu, l'émetteur de lumière (7) étant placé dans l'évidement sous l'ouverture, les conducteurs (8,8') étant placés dans l'évidement et présentant leurs extrémités extérieures traversant le fond ouvert de l'évidement, le couvercle présentant des fixations (12,12') pour retenir les conducteurs dans l'évidement, et les moyens d'indication (9,10,11) étant placés sur le couvercle.

**Patentansprüche**

1. Kombination von

einer elektrischen Zahnbürste (21), die eine Batterie (24) enthält; und

einer Spannungsprüfungseinrichtung zum Prüfen des Zustandes der Batterie, wobei die Zahnbürste enthält:

einen langgestreckten Handgriff (22), der an seinem einen Ende einen Griffbereich (23) und an seinem anderen Ende einen mit Borsten (26) versehenen Kopfbereich aufweist, wobei die Batterie in dem Griffbereich angeordnet ist;

ein elektrisch leitendes Element (29), das auf dem Äußeren des Griffbereiches angebracht und elektrisch mit einem Pol der Batterie verbunden ist; und

einen elektrisch leitenden Stab (25), der in dem Handgriff angeordnet ist und sich in dessen Längsrichtung von der Batterie in die Nähe der Borsten erstreckt, wobei ein Ende des Stabes elektrisch mit dem anderen Pol der Batterie verbunden ist und ein Bereich des Stabes über mindestens einen Schlitz (27,28) in dem Kopfbereich gegen das Äußere des Kopfbereiches freiliegt, wobei die Spannungsprüfungseinrichtung enthält:

einen langgestreckten Einrichtungskörper (1), der nahe der Zahnbürste positionierbar und in Längsrichtung derselben zwischen dem elektrisch leitenden Element und dem freiliegenden Bereich des Stabes erstreckbar ist;

ein lichtaussendendes Element (7), das im Inneren des Körpers angebracht und von der Außenseite des Körpers sichtbar ist;

ein Paar von elektrischen Leitern (8,8'), die von dem Körper getragen sind und sich in entgegengesetzten Richtungen von dem lichtaussendenden Element weg erstrecken, wobei die Leiter freiliegende, in Längsrichtung voneinander beabstandete äußere Enden aufweisen, die von dem Körper nahe von gegenüberliegenden Enden desselben nach außen vorspringen und an den Orten des elektrisch leitenden Elementes bzw. des freiliegenden Bereiches des Stabes entsprechenden Orten angeordnet sind, so daß die äußeren Enden gleichzeitig das elektrisch leitende Element bzw. den freiliegenden Bereich des Stabes berühren können, wobei die Leiter mit inneren Enden mit dem lichtaussendenden Element verbunden sind; und

Anzeigemittel (9,10,11; oder 14) auf dem Körper zum Anzeigen der Richtung, in der der Körper zum Prüfen der Batterie bezüglich der Zahnbürste in Lage gebracht werden sollte, wodurch, wenn die äußeren Enden der Leiter das elektrisch leitende Element bzw. den freiliegenden Bereich des Stabes berühren, die Aussendung von Licht durch das lichtaussendende Element vom Zustand der Batterie abhängig ist.

2. Kombination nach Anspruch 1, bei der die Anzeigemittel eine Markierung umfassen, die anzeigt, mit welchem Pol mindestens einer der elektrischen Leiter (8,8') elektrisch verbunden werden sollte.

3. Kombination nach Anspruch 1 oder 2, bei der die Anzeigemittel Schriftzeichen (14) umfassen.

4. Kombination nach Anspruch 3, bei der die Schriftzeichen (14) einen Teil der Zahnbürste identifizieren.

5. Kombination nach einem der vorhergehenden Ansprüche, bei der die Anzeigemittel ein Bild (10) umfassen.

6. Kombination nach einem der vorhergehenden Ansprüche, bei der das lichtaussendende Element (7) so angebracht ist, daß es einer Öffnung (6) in dem Körper (1) gegenüberliegt.

7. Kombination nach einem der vorhergehenden Ansprüche, bei der der Körper (1) zwei Teile (2,4) aufweist, die so zusammengefügt sind, daß sie den Körper bilden, wobei der letztere einen inneren Hohlraum (3) aufweist, in dem das lichtaussendende Element (7) und die beiden elektrischen Leiter (8,8') aufgenommen sind.

8. Kombination nach Anspruch 7, bei der der Körper (1) ein schachtelförmiger Körper ist.

9. Kombination nach Anspruch 7, bei der der Körper (1) im wesentlichen rechteckig ist und ein Gehäuse (2) umfaßt, das eine langgestreckte an ihrer Oberseite offene Vertiefung (3) aufweist, und eine die obere Seite der Vertiefung bedeckende Abdeckung (4), wobei die Abdeckung eine im wesentlichen in der longitudinalen Mitte derselben durch diese hindurchgehende Öffnung (6) aufweist, das Gehäuse zwei nahe den gegenüberliegenden longitudinalen Enden des Gehäuses angeordnete und sich von der Vertiefung durch den Boden des Gehäuses erstreckende Löcher (5,5') aufweist, das lichtaussendende Element (7) in der Vertiefung unter der Öffnung angeordnet ist, die Leiter (8,8') in der Vertiefung angeordnet und so gebogen sind, daß sie in einer Richtung von dem Körper weg auseinanderlaufen, und die Anzeigemittel (9,10,11) auf der Abdeckung vorgesehen sind.

10. Kombination nach einem der Ansprüche 1 bis 6, bei der der Körper (1) im wesentlichen rechteckig ist und eine Abdeckung (4) umfaßt, die eine Basiswand und sich von der Basiswand nach unten erstreckende und eine an ihrem Boden offene, langgestreckte Vertiefung begrenzende Seiten- und Endwände aufweist, wobei die Basiswand im wesentlichen in deren longitudinaler Mitte eine durch diese hindurchgehende Öffnung (6) hat, das lichtaussendende Element (7) in der Vertiefung unter der Öffnung angeordnet ist, die Leiter (8,8') in der Vertiefung angeordnet sind und mit ihren äußeren Enden durch den offenen Boden der Vertiefung vorspringen, die Abdeckung Fixiermittel (12,12') zum Halten der Leiter in der Vertiefung aufweist und die Anzeigemittel (9,10,11) auf der Abdeckung vorgesehen sind.

# FIG. 1

# FIG. 2

# FIG. 3

# FIG. 4

TESTER

EP 0 207 678 B1

# FIG. 5

# FIG. 6

# FIG. 7

9

## FIG. 8

## FIG. 9

## FIG. 10

BRISTLES
SIDE

## FIG. 11

BRISTLES
(−) SIDE

## FIG. 12

FIG. 13

FIG. 14

FIG. 15

FIG. 16

FIG. 17